Europäisches Patentamt

European Patent Office

Office européen des brevets

(11) Publication number: **0 436 038 A1**

# EUROPEAN PATENT APPLICATION
## published in accordance with Art. 158(3) EPC

(21) Application number: 90910930.8

(22) Date of filing: 11.07.90

(86) International application number:
PCT/JP90/00889

(87) International publication number:
WO 91/01569 (07.02.91 91/04)

(51) Int. Cl.⁵: **H01L 29/784**

(30) Priority: 14.07.89 JP 183106/89
14.07.89 JP 183108/89
18.07.89 JP 186681/89

(43) Date of publication of application:
10.07.91 Bulletin 91/28

(84) Designated Contracting States:
DE FR GB NL

(71) Applicant: SEIKO INSTRUMENTS &
ELECTRONICS LTD.
31-1, Kameido 6-chome
Koto-ku Tokyo 136(JP)

(72) Inventor: AOKI, Kenji Seiko Instruments Inc.
31-1, Kameido 6-chome Koto-ku
Tokyo 136(JP)

(74) Representative: Fleuchaus, Leo, Dipl.-Ing. et al
Melchiorstrasse 42
W-8000 München 71(DE)

(54) SEMICONDUCTOR DEVICE AND METHOD OF PRODUCING THE SAME.

(57) An insulated gate field-effect transistor used as a switching element in computers and a method of producing the same. In order to improve dynamic characteristics of the transistor by decreasing the junction capacitance between a substrate (1) and a source (7) or a drain (8), an an insulating layer (2) is provided under the source region and the drain region. In order to decrease the drop of carrier mobility and to suppress the short channel effect, furthermore, the impurity concentration is lowered on the surface of the semiconductor layer just under the gate and is heightened on the side of the substrate.

EP 0 436 038 A1

## SEMICONDUCTOR DEVICE AND METHOD FOR MAKING THE SAME

### FIELD OF THE INVENTION

The present invention relates to a metal-oxide semiconductor field effect transistor (as will be, hereinafter, abbreviated to "MISFET") which is used as a switching element of a computer.

### BACKGROUND OF THE INVENTION

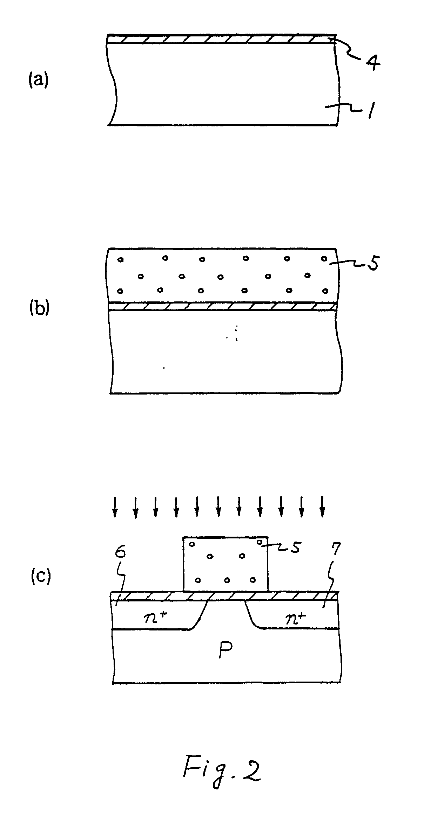

The process of the prior art for making the metal-oxide semiconductor field effect transistor ( as will be, hereinafter, abbreviated to "MISFET" ) comprises a step of forming a gate insulating film 4 on a surface portion of a semiconductor substrate 1 as shown in Fig.2 (a), a step of filming a gate electrode material 5 through the gate insulating film 4 as shown in Fig.2 (b), and a step of forming a source 6 and a drain 7 by an ion implantation after having paterned a gate electrode 5 into a predetermined form as shown in Fig.2 (c). In this case, the drain 7 and the semiconductor substrate 1 has a PN + junction.

However, a junction capacitance (as will be, hereinafter, called $C_D$ for short ) between the substrate and the drain is a factor for dropping the dynamic characteristics of a CMOS inverter, for example, and accordingly has to be reduced.

An object of the present invention is to provide a MISFET which has a small junction capacitance between the substrate and the drain and improved dynamic characteristics.

### DISCLOSURE OF THE INVENTION

In order to solve the above-specified problems of the prior art, the present invention provides the following means.

First, an impurity concentration of the surface side portion of the semiconductor layer just under the gate is made low and that of the substrate side portion is made high to prevent short channel effect. In order to realize this structure, the present invention employs either the molecular beam epitaxial growth method (MBE) or the molecular layer epitaxial growth method (MLE) which can accurately control the layer thickness in the order of 0.1 $\mu$m or less and also can form a single crystal at low temperature.

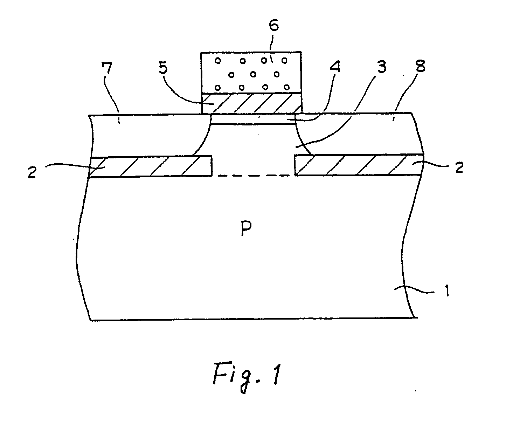

According to the present invention, an insulating film layer 2 is provided below the source region and the drain region as shown in Fig.1 thereby to reduce the junction capacitance between the substrate 1, and the source 7 and the drain 8.

Since the impurity concentration is high in the semiconductor layer between the source region and the drain region except the vicinity of the surface, it is possible to reduce the drop of the carrier mobility and to suppress the short-channel effect. Moreover, the junction capacitance between the source and drain regions, and the substrate can be drastically reduced to improve the dynamic characteristics.

### BRIEF DESCRIPTION OF THE DRAWINGS

Fig.1 is a cross-sectional view showing a structure of a semiconductor device of a first embodiment according to the present invention;

Fig.2 is a cross-sectional view showing a process flow for making a MISFET according to the prior art;

Figs.3 (a)-(c) are cross-sectional views showing a process flow for making a semiconductor device of a first embodiment according to the present invention;

Fig.4 is a cross-sectional view showing a process flow of a second embodiment;

Fig.5 is a graph showing a concentration profile of boron of a semiconductor layer just under a gate in the depth direction in Fig.4(c).

Figs.6 (a)-(c) are cross-sectional views showing a process flow for making an N channel MISFET of a third embodiment according to the present invention.

### THE BEST MODE FOR CARRYING OUT THE INVENTION

The present invention will be described in detail with reference to the attached drawings.

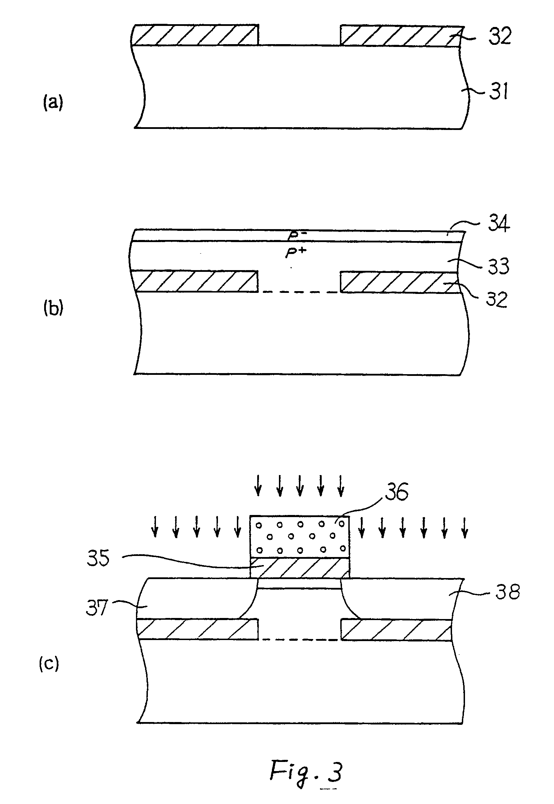

A first embodiment of the present invention will be explained with reference to Fig.1 and Figs.3 (a)-(c). As shown in Fig.3 (a), an insulating film 32 of $SiO_2$ or SiN etc. is formed on a P type silicon substrate by CVD or thermal oxidation or sputtering, and then is patterned. Next, in Fig.3(b) step, the molecular layer epitaxial growth method is used to form a P + type epitaxially grown layer 33 and subsequently a P- type epitaxially grown layer 34. After this, in Fig.3 (c) step, a gate insulating film 35 and a gate 36 are formed, and then a source 37 and a drain 38 are formed by ion implantation. The cross-sectional view of the structure of the MOSFET fabricated by the above steps is shown in Fig.1. A first featuring point in Fig.1 is that the insulating film 2 is formed between the P type silicon substrate and the source 7 and also between the P type silicon srbstrate and the drain 8. This point drastically reduces the junction capacitance between the P type silicon substrate 1 and the source 7 and between the P type silicon substrate 1 and the drain 8. A second featuring point in Fig.1 is that the semiconductor layer between the source 7 and the drain 8 is composed of the epitaxially grown layer 3 having a high impurity concentration and the epitaxially grown layer 4 having a low impurity concentration. In the first embodiment of the present invention, the epitaxially grown layer 3 has a thickness of about 2,500 Å ,and the epitaxially grown layer 4 has a thickness of about 700 Å, for example. Since the impurity concentration just below the channel is so high as to suppress extension of a depletion layer from the drain side to the channel side, the structure is hard to invite the short-channel effect.

As has been described herein before, according to the present invention, the junction capacity between the source 7, the drain 8 and the substrate 1 is drastically reduced to make it possible to improve the dynamic characteristics of the transistor and to realize a MISFET which is excellent in short-channel resistance characteristics. When the low impurity concentration layer 4 of the semiconductor layer just under the gate is thicker than the channel and thinner than the depletion layer, a fast operation can be realized. In addition, the threshold voltage of MISFET can be determined by controlling the thickness of the semiconductor layer 4. An ideal thickness of the low impurity concentration layer is 200 - 800 Å.

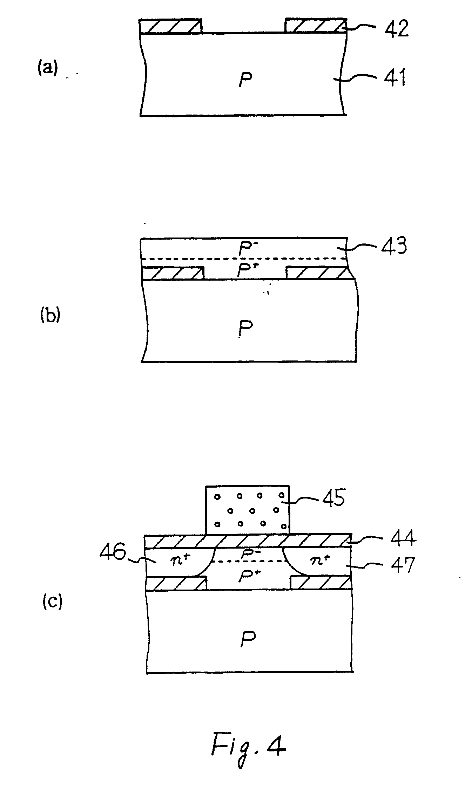

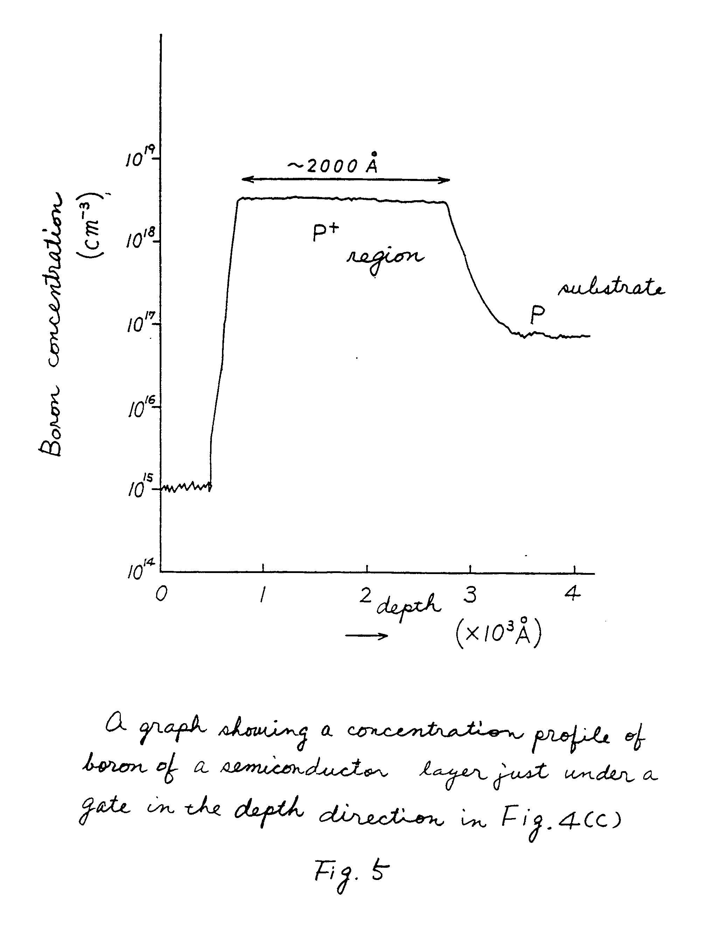

Next, a second embodiment of the present invention will be described with reference to Figs.4 and 5. Figs.4 (a)-(c) are cross-sectional views showing a process flow for making a MISFET according to the present invention. In Fig.4 (a) step, an insulating film 42 is formed on a semiconductor substrate 41 and then etched only at its region just below the portion where a gate will be formed so as to expose the surface of the semiconductor substrate. Next, in Fig.4 (b) step, an epitaxial growth is accomplished by seeding the exposed region of the surface of the semiconductor substrate. In this case, a single crystal is formed by the lateral epitaxial growth on the insulating film 42 as well. Moreover, if the epitaxial growth is effected by the molecular layer epitaxial method (MLE), the thickness of the epitaxially grown film can be formed in the order of accuracy of a single atomic layer and a profile of impurity concentration becomes steep. In the case of using the molecular layer epitaxial growth method, for example, the profile of the epitaxially grown layer is composed of a P+ layer of about 2,000 Å and P- layer of about 500 Å as shown in Fig.5 and is so steep that the transitional region has a width of about 200 Å. In this case, dicholorosilane gas ($SiH_2Cl_2$) is used as a source gas of silicon, and diborane ($B_2H_6$) is used as a doping source to form the P+ layer. However, the P- layer is formed by non-doped growth without diborane gas. Next, in Fig 4 (c) step, a gate insulating film 44 and a gate electrode 45 are formed, and a source 46 and a drain 47 are then formed by ion implantation.

The MISFET fabricated by the above mentioned method is featured in that the drain capacitance $C_D$ is low whereas the current drivability is high. Further, since the impurity concentration just below the channel is high, the drain depletion layer is suppressed from extending to the region just below the gate so that the short channel effect is hard to occur. It is possible to provide a novel method for fabricating a transistor having a low drain capacitance and a high current drivability.

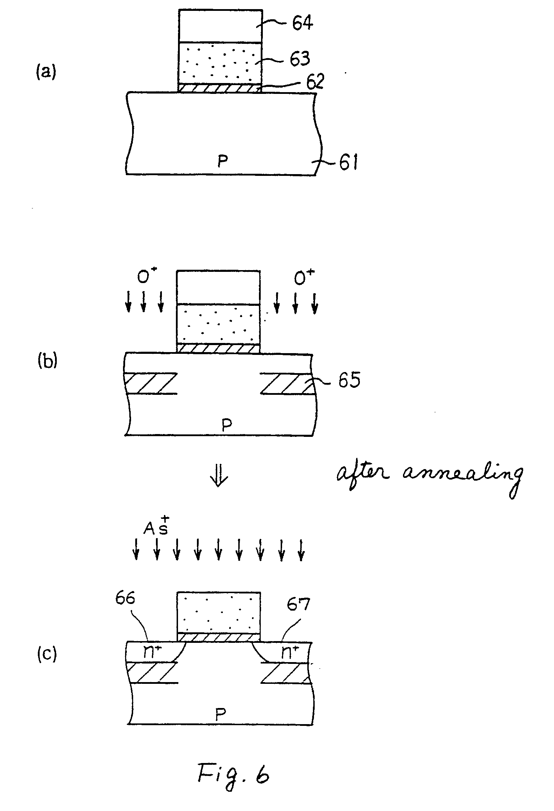

A third embodiment will be described in detail with reference to Fig.6. Figs.6 (a)-(c) are cross-sectional views showing a process flow for making an N channel MOSFET according to the present invention. Fig.6 (a) shows the state in which a gate insulating film 62 is formed on a semiconductor substrate 61 of low resistance and in which a gate electrode 63 is then patterned by the use of a resist 64. Next, in Fig.6 (b) step, oxygen ions are implanted while leaving the above resist 64 as it is, to form an $SiO_2$ insulating film 65 below the surface of the semiconductor substrate 61 ( i.e. , closer to the substrate ). After this, the resist 64 is removed, and the damage which has been induced in the surface of the substrate 61 at the time of the oxygen ion implantation can be restored by annealing.

After this, as shown in Fig.6 (c), the resist 64 is removed to implant arsenic ions to form n+ source 66 and drain 67. The MOSFET thus fabricated is featured in its structure wherein the junction capacitance ( or parasitic capacitance ) between the semiconductor substrate 61, and the source 66 and the drain 67 is small.

Further, the above embodiments show the formation of MISFET using the semiconductor substrates 1, 31, 41 and 61. However, a well may be used instead of a substrate.

**Claims**

1. A semiconductor device in which a gate is formed on the portion between source and drain regions through an insulating film and in which a semiconductor layer just below the gate has a conductivity type opposite to that of the source and drain regions, characterized in that an insulating film is formed below the source and drain regions.

2. A semiconductor device according to claim 1, wherein the insulating film layer below the source and drain regions is made of $SiO_2$ or SiN.

3. A semiconductor device according to claim 1, wherein the impurity concentration of the semiconductor layer in the vicinity of the surface is low and that of the bulk side is high.

4. A semiconductor device according to claim 3, wherein the semiconductor layer just below the gate comprises plural epitaxially grown layers.

5. A semiconductor device according to claim 3, wherein the layer in the vicinity of the surface of the semiconductor layer having low impurity concentration is thinner than a depletion layer.

6. A semiconductor device according to claim 3, wherein the thickness of the layer in the vicinity of the surface of the semiconductor layer having low concentration is 200 - 800 Å.

7. A method for making a semiconductor device comprising; a first step of forming an insulating film on, at least, a part of a surface of a first conductivity type semiconductor region a second step of providing a semiconductor layer of the same conductivity type as the first conductivity type on the seimconductor region including the insulating film, and a third step of forming a source and a drain of a second conductivity type different from the first conductivity type by an ion implantation after having formed a gate electrode on the semiconductor layer through a gate insulating film, wherein at least the insulating film is provided below the source and the drain.

8. A method for making a semiconductor device acccording to claim 7, wherein the second step of providing the first conductivity semiconductor layer is a step to carry out a lateral epitaxial growth seeding the exposed region of the surface of the semiconductor.

9. A method for making a semiconductor device according to claim 7, wherein an impurity concentration of the semiconductor layer formed at the second step increases in proportion to a distanc from the gate insulating film.

10. A method for making a semiconductor device according to claim 8 or 9, wherein the molecular layer epitaxial growth method or the molecular beam epitaxial growth method is used at the second step of forming the semiconductor layer.

11. A method for making a semiconductor comprising; a first step of forming a gate insulating film on a first conductivity type semiconductor substrate and a gate electrode through the gate insulating film, a second step of forming an oxide film below the regions of the semiconductor substrate, where a source and a drain are to be formed by an implantation of oxygen ions while leaving a resist on the gate electrode formed at the first step, and a third step of forming the source and the drain of a second conductivity type by introducing impurity atoms of the second conductivity type different from the first conductivity type.

Fig. 1

(a)

(b)

(c)

Fig. 2

(a)

(b)

(c)

Fig. 3

(a)

$P$

42

41

(b)

$P^-$

$P^+$

$P$

43

(c)

45

46  $n^+$  $P^-$  $n^+$

$P^+$

$P$

44

47

Fig. 4

A graph showing a concentration profile of boron of a semiconductor layer just under a gate in the depth direction in Fig.4(c)

Fig. 5

Fig. 6

# INTERNATIONAL SEARCH REPORT

International Application No PCT/JP90/00889

### I. CLASSIFICATION OF SUBJECT MATTER (if several classification symbols apply, indicate all) [6]

According to International Patent Classification (IPC) or to both National Classification and IPC

Int. Cl$^5$     H01L29/784

### II. FIELDS SEARCHED

| Minimum Documentation Searched [7] | |
| --- | --- |
| Classification System | Classification Symbols |
| IPC | H01L29/784 |

Documentation Searched other than Minimum Documentation
to the Extent that such Documents are Included in the Fields Searched [8]

| | |
| --- | --- |
| Jitsuyo Shinan Koho | 1965 - 1990 |
| Kokai Jitsuyo Shinan Koho | 1971 - 1990 |

### III. DOCUMENTS CONSIDERED TO BE RELEVANT [9]

| Category [*] | Citation of Document, [11] with indication, where appropriate, of the relevant passages [12] | Relevant to Claim No. [13] |
| --- | --- | --- |
| X | JP, A, 56-135969 (Fujitsu Ltd.),<br>23 October 1981 (23. 10. 81),<br>& EP, A1, 37261 & US, A, 4381202<br>& EP, B1, 37261 | 1 - 10 |
| X | JP, A, 63-72164 (Yokogawa-Hewlett-<br>Packard, Ltd.),<br>1 April 1988 (01. 04. 88),<br>& DE, A1, 3726842 & US, A, 4810664 | 1 - 6,<br>11 |
| Y | JP, A, 63-169065 (Seiko Instruments Inc.),<br>13 July 1988 (13. 07. 88),<br>& EP, A1, 274278 & US, A, 4843877 | 4 - 6<br>9, 10 |

* Special categories of cited documents: [10]
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure. use. exhibition or other means
"P" document published prior to the international filing date but later than the priority date claimed

"T" later document published after the international filing date or priority date and not in conflict with the application but cited to understand the principle or theory underlying the invention
"X" document of particular relevance: the claimed invention cannot be considered novel or cannot be considered to involve an inventive step
"Y" document of particular relevance: the claimed invention cannot be considered to involve an inventive step when the document is combined with one or more other such documents, such combination being obvious to a person skilled in the art
"&" document member of the same patent family

### IV. CERTIFICATION

| Date of the Actual Completion of the International Search | Date of Mailing of this International Search Report |
| --- | --- |
| September 26, 1990 (26. 09. 90) | October 15, 1990 (15. 10. 90) |
| International Searching Authority | Signature of Authorized Officer |
| Japanese Patent Office | |

Form PCT ISA 210 (second sheet) (January 1985)